# FASCICULE DE BREVET EUROPEEN

(11) **EP 0 412 855 B1**
(45) Date de publication et mention de la délivrance du brevet: **09.03.1994**
(21) Numéro de dépôt: 90400817.4
(22) Date de dépôt: 23.03.1990
(51) Int. Cl.: H03H 9/145, H03H 9/02

(54) **Transducteurs électrique/acoustique et acoustique/électrique pour dispositif à ondes de surface à diffraction réduite et dispositif à ondes de surface correspondant**
Elektrisch/akustischer und akustisch/elektrischer Wandler für Oberflächenwellenanordnung mit niedriger Diffraktion und entsprechende Oberflächenwellenanordnung
Electric/acoustic and acoustic/electric transducers for surface wave device with reduced diffraction and corresponding surface wave device

(30) Priorité: 10.08.1989 FR 8910785
(43) Date de publication de la demande: 13.02.1991
(73) Titulaire: DASSAULT ELECTRONIQUE, F-92214 Saint-Cloud (FR)
(72) Inventeur: Noel, Benoît, F-78960 Voisins Le Bretonneux (FR); Foure, Jean-Louis, F-91370 Verrières Le Buisson (FR)
(74) Mandataire: Plaçais, Jean-Yves

(56) Documents cités:
- GB-A- 2 145 893
- US-A- 4 126 838
- HEWLETT-PACKARD JOURNAL, vol. 33, no. 1, janvier 1982, pages 3-8, Amstelveen, NL; W.R. SHREVE: "Signal processing using surface acoustic waves"

## Description

Les dispositifs à ondes de surface sont d'usage courant pour des traitements de signaux de haute fréquence, avec des retards qui peuvent être dispersifs, ou non dispersifs.

Pour réaliser ces dispositifs, on part d'un mince substrat piezo-électrique plan. Par microlithographie ou par d'autres techniques de micro-usinage, on dépose sur une grande face de ce substrat une rangée de doigts conducteurs fins parallèles. En prévoyant au moins deux transducteurs de ce genre, on réalise un dispositif à ondes de surface dont aussi bien l'entrée que la sortie sont électriques.

La mise au point de ces transducteurs suppose de faire des choix de compromis entre les caractéristiques que l'on désire, électriques d'une part et acoustiques d'autre part, compte tenu des limitations technologiques qui leur sont propres. Par exemple, l'homme de l'art sait que la largeur d'un doigt est en principe le quart de la longueur d'onde acoustique que l'on souhaite lui voir traiter. De son côté, la longueur des doigts va définir la taille d'une sorte de "source acoustique" qui va rayonner dans le substrat. Plus précisément, cette longueur de doigt définit l'ouverture de la source rayonnante que constitue chaque paire de doigts. Cela étant, sur le plan électrique, lorsqu'on augmente la longueur d'un doigt, on augmente également la capacité électrique associée.

Il se pose alors un problème, lorsqu'on veut réaliser des transducteurs électro-acoustiques à grand nombre de doigts. Ou bien l'on réduit la longueur des doigts. Mais alors les sources rayonnantes constituées par ceux-ci deviennent trop petites, et l'on rencontre des modes de propagations multiples résultant d'un phénomène de diffraction, dû à une ouverture acoustique trop réduite du transducteur. Ou bien, si l'on choisit la longueur des doigts en fonction des conditions qu'ils doivent vérifier au plan acoustique, on retrouve alors au plan électrique une capacité du transducteur qui est considérable, et qui va se comporter comme un court-circuit pour les signaux de haute fréquence que l'on veut lui appliquer.

La présente invention vient apporter une solution à ce problème.

L'invention s'applique à un transducteur électrique/acoustique, d'entrée ou un transducteur acoustique/électrique de sortie en particulier pour dispositif à ondes de surface, qui comporte, sur une grande face d'un substrat piezo-électrique plan :
- deux plages conductrices d'entrée ou de sortie, séparées par un ruban de substrat, sur lequel elles étendent des doigts parallèles respectifs qui s'imbriquent selon un motif choisi pour former une rangée de doigts le long de ce ruban,
- la direction générale du ruban étant généralement inclinée sur la direction des doigts, et
- des moyens électriques d'entrée pour appliquer des signaux de haute fréquence entre les plages, de façon à former des sources d'ondes acoustiques de surface sur le substrat ou de sortie pour extraire les signaux détectés par le dispositif.

Selon un premier aspect de l'invention, l'une au moins des deux plages conductrices d'entrée ou de sortie est subdivisée en sous-plages, électriquement séparées, tandis que les moyens électriques d'entrée comprennent un répartiteur (diviseur de puissance), propre à alimenter séparément les sous-plages d'entrée et que les moyens électriques de sortie comprennent un coupleur propre à combiner les signaux électriques provenant des sous-plages de sortie.

La Demanderesse a en effet observé que les sous-plages en question définissent sur le plan électrique une pluralité de transducteurs indépendants, tandis que sur le plan acoustique ceux-ci se comportent comme un seul et unique transducteur. Elle a également observé qu'il est possible d'alimenter électriquement les transducteurs indépendants par des diviseurs de puissance, recevant un seul signal d'entrée, et propres à le répartir, éventuellement d'une manière pondérée, sur les différents transducteurs élémentaires.

L'invention s'applique particulièrement au cas où les doigts présentent des géométries individuelles qui varient progressivement le long du ruban de substrat pour couvrir une large bande de fréquences (bien entendu, on peut conférer dans ce cas au répartiteur une fonction sélective en fréquence).

Bien que le nombre de sous-plages que l'on peut réaliser ne soit pas limité, la Demanderesse considère actuellement que l'on doit réaliser quelques sous-plages, typiquement trois, quatre ou cinq sous-plages.

Un second aspect de l'invention s'applique au cas où les doigts ont une longueur variable le long de la rangée, en vue d'obtenir un diagramme de rayonnement acoustique particulier. La Demanderesse a observé qu'il en résulte des propriétés de diffraction différentes des doigts, en fonction de leur longueur et par conséquent de leur position sur la rangée. Dans ce cas, le répartiteur réalise une alimentation pondérée (éventuellement sélective en fréquence) en fonction de la distribution des longueurs variables de doigts.

Une application préférentielle de transducteur pondéré est celle du transducteur dit "apodisé", possédant une loi de pondération du type (sin X)/X. Un tel transducteur possède une zone centrale non diffractante encadrée par deux zones latérales diffractantes. Le découpage alors des sous-plages s'effectue en correspondance, avec une sous-plage centrale généralement étroite et deux sous-plages latérales généralement plus larges qui l'encadrent, et sont alimentées sous signal atténué, avantageusement par division à partir du signal d'alimentation de la sous-plage centrale. Cela permet ainsi d'augmenter la longueur des doigts dans des plages latérales et de limiter ainsi la diffraction.

Enfin, et c'est là un autre aspect de l'invention, le répartiteur peut être implanté sur le substrat, ce qui confère au dispositif des caractéristiques d'autonomie et de modularité fort intéressantes pour les applications.

L'invention a également pour objet un dispositif à ondes de surface du type comprenant, sur une grande face d'un substrat piézo-électrique plan :
- un transducteur électrique/acoustique d'entrée comprenant :
   . deux plages conductrices d'entrée, séparées par un ruban de substrat, sur lequel elles étendent des doigts parallèles respectifs qui s'imbriquent selon un motif choisi pour former une rangée de doigts le long de ce ruban,
   . la direction générale du ruban étant inclinée sur la direction des doigts,
   . des moyens électriques d'entrée pour appliquer des signaux de haute fréquence entre les plages, de façon à former des sources d'ondes acoustiques de surface, et
- un transducteur acoustique/électrique de sortie comprenant :
   . deux plages conductrices de sortie, séparées par un ruban de substrat, sur lequel elles étendent des doigts parallèles respectifs qui s'imbriquent selon un motif choisi pour former une rangée de doigts le long de ce ruban,
   . la direction générale du ruban étant inclinée sur la direction des doigts,
   . des moyens électriques de sortie pour extraire les signaux détectés par le dispositif.

Selon l'invention, l'une au moins des deux plages conductrices de chaque transducteur est subdivisée en sous-plages, électriquement séparées, et en ce que les moyens électriques d'entrée comprennent un répartiteur, propre à alimenter séparément les sous-plages associées audit transducteur d'entrée tandis que les moyens électriques de sortie comprennent un coupleur propre à combiner les signaux électriques provenant des sous-plages associées audit transducteur de sortie.

D'autres caractéristiques et avantages de l'invention apparaitront à l'examen de la description détaillée ci-après, et des dessins annexés, sur lesquels :
- la figure 1 est un schéma illustrant un exemple des dispositifs auxquels peut s'appliquer l'invention ;
- la figure 2 illustre une structure dite en doigts simples pour former une rangée de transducteurs électriques/acoustiques pour dispositif à ondes de surface ;
- la figure 3 illustre le dispositif de la figure 2, modifié selon la présente invention ;
- la figure 4 illustre schématiquement un premier exemple d'application de l'invention ; et
- la figure 5 illustre schématiquement un second exemple d'application de l'invention.

Il est clair que la géométrie est très importante pour la présente invention. De plus les dessins annexés sont, pour l'essentiel, de caractère certain. En conséquence, ils sont à considérer comme incorporés à la description et pourront non seulement servir à mieux faire comprendre celle-ci, mais aussi le cas échéant contribuer à la définition de l'invention.

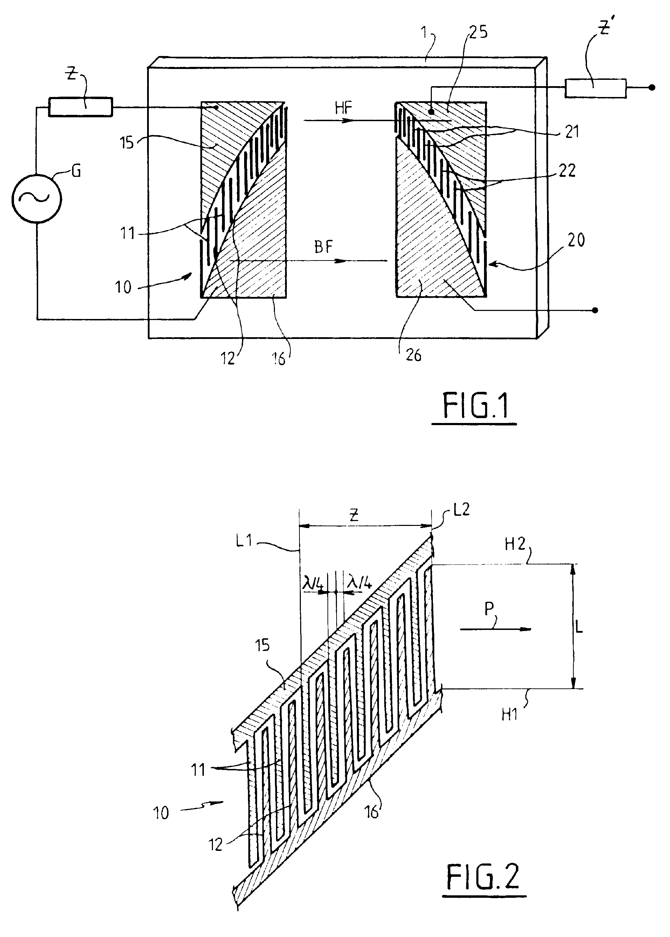

La figure 1 fait apparaître un dispositif à ondes de surface classique, constitué d'un substrat piézo-électrique 1 dont l'épaisseur peut être de l'ordre 0,5 mm. Ses autres dimensions vont de quelques millimètres à quelques dizaines de millimètres, voire plus.

Sur une grande face de ce substrat sont disposées deux rangées de doigts 10 et 20. Ici, la rangée de doigts 10 est côtoyée par deux plages conductrices 15 et 16, électriquement séparées, par exemple en aluminium et d'épaisseur 200 nanomètres environ. En alternance, les doigts 11 sont connectés à la plage 15 tandis que les doigts 12 sont connectés à la plage 16. Il en est de même pour la seconde rangée de doigts 20 avec les plages 25 et 26 auxquelles sont connectés respectivement les doigts 21 et les doigts 22.

La figure 1 fait encore apparaître que les doigts sont plus resserrés dans la partie haute des rangées de doigts que dans la partie basse. Ils sont également plus étroits, ce que le dessin ne montre pas. Il en résulte que pour la partie haute de la figure 1, le couplage entre les doigts situés sur la même horizontale interviendra dans la partie haute de la gamme de fréquences dans laquelle opère le dispositif à ondes de surface. A l'opposé, au bas de la figure 1, les doigts sont plus espacés, leurs largeurs individuelles (dans la direction de propagation) sont plus grandes. En conséquence, le couplage intéressera ici la partie basse de la gamme de fréquences concernée. On obtient ainsi une ligne dispersive qualifiée habituellement de "Down Chirp", dans la littérature anglo-saxonne. Le principe s'applique également aux lignes dispersives dites "Up Chirp", c'est-à-dire comportant les doigts les plus resserrés dans la partie basse du transducteur que dans la partie haute.

Un autre aspect important dans ce genre de dispositif est qu'on cherche à obtenir une propagation acoustique localisée entre une partie réduite du transducteur-émetteur ou transducteur électrique/acoustique d'entrée, qui est la rangée 10 de doigts, et une partie limitée du transducteur-récepteur ou transducteur acoustique/électrique de sortie, qui est la rangée 20 de doigts. Sur la figure 1, cela correspond sensiblement à une propagation horizontale en ligne droite entre deux rangées.

On s'intéressera maintenant essentiellement au transducteur-émetteur, qui est supposé être ici la rangée de doigts 10. Il reçoit entre ses plages 15 et 16 des signaux haute fréquence d'alimentation qui proviennent d'une source G à travers une impédance Z. Une impédance Z' branchée à la plage conductrice 25 permet d'obtenir les signaux détectés par le dispositif à ondes de surface formé par le transducteur d'entrée et le transducteur de sortie.

Pour les raisons déjà indiquées, on rencontre des difficultés lorsque le transducteur doit comporter un très grand nombre de doigts, par exemple si on souhaite le voir fonctionner en haute fréquence avec une dispersion importante car le nombre de doigts est lié au produit de la fréquence par le temps de dispersion, ou plutôt le temps de propagation d'un bout à l'autre du transducteur. En effet, ou bien l'on réduit la longueur des doigts, de façon à limiter la capacité existant entre les plages 15 et 16, pour éviter que le transducteur ne se comporte comme un court-circuit vis-à-vis du générateur et on obtient alors des phénomènes de diffraction acoustique, ou bien on conserve la bonne ouverture acoustique de manière à ne pas obtenir de phénomène de diffraction acoustique et dans ce cas, la capacité entre les plages 15 et 16 est élevée, et l'essentiel de la puissance du générateur sera alors absorbé dans l'impédance série Z, et donc perdu pour la transduction électrique/acoustique.

Dans un dispositif à deux transducteurs tel que celui de la figure 1, les deux rangées de doigts 10 et 20 sont inclinées par rapport à la direction principale de propagation des ondes acoustiques (l'horizontale). C'est pourquoi ces structures sont souvent appelées SLT pour "SLANTED Transducer" ou même ont conservé leur appellation ancienne de "Slanted acoustic correlator" ou SAC.

La figure 2 illustre avec plus de précision un exemple de rangée de doigts utilisables dans la structure de la figure 1.

En fait, les rangées de doigts telles que 10 et 20 comportent un nombre de doigts très élevé qui, de plus, comme on l'a déjà vu, vont avoir des caractéristiques qui se modifient d'une extrémité à l'autre de la rangée, et ce d'une façon progressive.

En fait, la figure 2 ne représente donc qu'une portion locale d'un transducteur, où l'on reconnait entre les plages schématisées en 15 et 16 des doigts 11 rattachés à la plage 15 et des doigts 12 rattachés à la plage 16. Dans cette portion locale, tant la largeur des doigts dans la direction de propagation P que l'intervalle entre doigts dans cette même direction sont égaux à un quart de longueur d'onde acoustique instantanée (locale).

L'ouverture de rayonnement acoustique est liée à la longueur L des doigts, pris individuellement. Cependant, sur le plan acoustique, on considère en général que c'est l'ensemble des morceaux de doigts de la rangée 10 qui sont situés entre les traits horizontaux H1 et H2 et généralement les traits verticaux L1 et L2 qui vont participer à l'émission de l'onde acoustique dans la direction P, qui est l'axe médian de la zone délimitée par les horizontales H1 et H2. C'est de là que résulte le problème déjà relevé, à savoir que si la taille L des doigts diminue, alors on ne se trouve plus en présence d'un rayonnement acoustique directionnel, mais au contraire d'un rayonnement acoustique suivant plusieurs directions, dû à des phénomènes de diffraction entre les fentes d'émission.

Comme déjà indiqué, si au contraire on maintient la longueur de doigt voulue pour des raisons acoustiques, alors la capacité totale du transducteur proprement dit atteindra des valeurs telles que son rendement deviendra très faible car l'impédance du transducteur sera très différente de celle du générateur.

Les limitations techniques qui résultent de ces phénomènes sont habituellement mesurées par les hommes de l'art sous la forme du produit de la bande passante par le temps de dispersion maximale permis. On atteint actuellement des produits B.T. égaux à 400 environ.

L'homme de l'art comprendra que la présente invention permet d'augmenter raisonnablement environ d'un facteur cinq ce produit caractéristique.

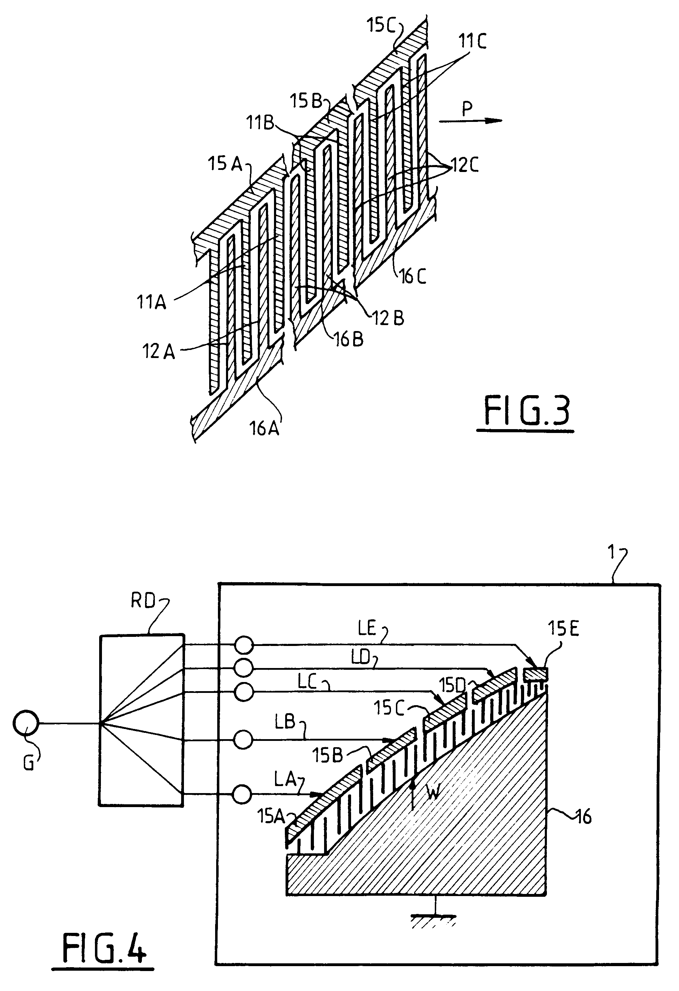

La figure 3 représente le même motif que la figure 2, mais découpé selon l'invention, c'est-à-dire que les plages métalliques 15 et 16 sont maintenant divisées en sous-plages 15A, 15B, 15C, et 16A, 16B, 16C, qui se correspondent, c'est-à-dire qui ont des doigts imbriqués respectifs 11A et 12A, 11B et 12B, ainsi que 11C et 12C.

Cette illustration de la figure 3 est donnée uniquement pour bien faire comprendre l'invention, remarque étant faite que la répétition à l'identique des doigts telle qu'elle apparaît sur les figures 2 et 3 n'est pas conforme à la réalité pour les raisons déjà indiquées.

En pratique, l'homme de l'art remarquera tout d'abord que les doigts ont en principe des dimensions transversales en largeur qui vont évoluer, et des longueurs qui vont elles aussi évoluer, comme cela apparait sur la figure 1.

De plus, la subdivision en plages selon l'invention peut ne se faire que d'un côté de la rangée de doigts, puisque cela suffit pour permettre la séparation électrique du transducteur élémentaire en une pluralité de "sous-transducteurs".

En conséquence, le montage de base de l'invention possède la structure illustrée sur la figure 4. On y reconnaît le substrat 1, avec une plage 16, d'une forme un peu particulière, et globalement mise à la masse. Le bord utile de la plage 16 est défini par une ligne courbe oblique se terminant vers le bas par un segment de droite horizontale. L'autre plage est définie par des segments successifs 15A, 15B, 15C, 15D et 15E de longueur variable, déterminée par le calcul.

A partir de l'une des bornes G du générateur est prévu un réseau répartiteur distributeur RD, qui alimente des plots situés sur le substrat 1, ces plots individuels étant reliés par des lignes LA à LE aux sous-plages 15A à 15E respectivement.

Le répartiteur distributeur RD peut être par exemple constitué par des diviseurs de puissance du commerce ou des diviseurs de puissance réalisés en technologie hybride.

L'homme de l'art comprendra que l'on alimente ainsi d'une manière électriquement indépendante des organes qui se comportent comme cinq transducteurs indépendants sur le plan électrique, mais qui par contre peuvent coopérer pour former un seul transducteur sur le plan acoustique, et travailler par exemple avec une autre rangée de doigts comme visible sur la figure 1.

Il est d'ailleurs concevable, mais pas forcément nécessaire, que le second ensemble de plages 25 et 26 soit agencé comme le premier, qui constitue le transducteur émetteur.

L'invention telle qu'elle vient d'être décrite s'applique d'une manière générale à tout transducteur dispersif incliné, en particulier à large bande, ou à haute performance.

Elle peut s'appliquer aussi, très avantageusement, à une classe un peu différente de transducteurs que l'on appelle transducteurs pondérés ou apodisés.

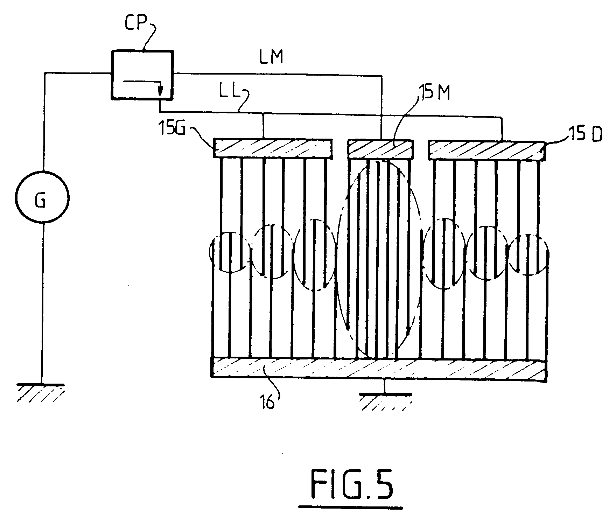

Un tel transducteur apodisé est illustré schématiquement sur la figure 5, avec le perfectionnement de l'invention.

Un transducteur pondéré possède d'une manière générale une loi d'émission acoustique du type (sin X)/X. Cela veut dire que, très schématiquement, si l'on trace l'enveloppe des extrémités des doigts qui le constituent, on obtient une figure voisine d'une fonction (sin X)/X, et qui apparaît quelque peu sur la figure 5.

En d'autres termes, sur cette figure, les plages 15 et 16 sont séparées par des doigts qui ne vont plus maintenant pratiquement jusqu'à l'autre plage, mais qui ont au contraire des longueurs variables pour respecter ladite loi du type (sin X)/X.

La Demanderesse a observé que dans un tel transducteur, la partie centrale est peu diffractante, tandis que les parties latérales, dont les zones de coopération entre doigts sont plus courtes, est plus fortement diffractante.

La mise en oeuvre de l'invention à des structures de ce type se fait alors de la manière suivante :
- la zone non diffractante centrale est associée à une sous-plage 15M de faible largeur (parallèlement à l'autre plage 16). Les zones latérales, plus diffractantes, peuvent être agrandies dans la direction des doigts par un facteur N et alimentées à partir du générateur par un coupleur d'atténuation N. On va donc alimenter la plage principale 15M par une ligne LM qui passe à travers la voie principale d'un coupleur à perte CP connecté au générateur de signaux G. La voie de perte de ce même coupleur CP est appliquée à une ligne LL qui alimente en même temps les deux sous-plages latérales 15G et 15D. On compense par une plus grande ouverture acoustique l'alimentation atténuée des sous-plages 15G et 15D.

On obtient ainsi un transducteur pondéré très avantageux où l'effet de diffraction acoustique est fortement atténué.

Le répartiteur d'énergie entre les différentes sous-plages pourra avantageusement être incorporé sur le substrat lui-même en utilisant des coupleurs hybrides ou à éléments répartis suivant des techniques bien connues en haute fréquence.

Il faut remarquer que l'invention s'applique à toute loi de pondération et pas seulement à celle du type (sin X)/X.

D'une façon générale, la présente invention peut s'appliquer à des doigts simples, à des doigts dédoublés ou à tout type de séquence d'accrochage des doigts. En d'autres termes, la largeur d'un doigt est sensiblement un sous-multiple prédéterminé de la demi-longueur d'onde acoustique associée à la fréquence que l'on veut voir traiter par ce doigt, tandis que la distance entre doigts adjacents est sensiblement égale à ce sous-multiple ou multiple de celui-ci. S'agissant du premier sous-multiple, cela donne le quart de longueur d'onde pour la largeur d'un doigt et la même valeur ou un multiple pour la distance entre doigts adjacents (la valeur multiple ne restant en principe qu'occasionnelle). Si le sous-multiple est d'ordre deux, on obtient alors le huitième de longueur d'onde, et l'autre dimension est également modifiée en conséquence.

Bien entendu la présente invention n'est pas limitée au mode de réalisation décrit, mais s'étend à toute variante conforme à son esprit.

## Revendications

1. Transducteur électrique/acoustique d'entrée ou transducteur acoustique/électrique de sortie, en particulier pour dispositif à ondes de surface, du type comprenant, sur une grande face d'un substrat piézo-électrique plan:
- deux plages conductrices d'entrée (15, 16) ou de sortie (25, 26), séparées par un ruban (10, 20) de substrat, sur lequel elles étendent des doigts parallèles respectifs (11, 12, 21, 22) qui s'imbriquent selon un motif choisi pour former une rangée de doigts le long de ce ruban,
- la direction générale du ruban (10,20) étant inclinée sur la direction des doigts,
- des moyens électriques d'entrée (G, Z) pour appliquer des signaux de haute fréquence entre les plages, de façon à former des sources d'ondes acoustiques de surface sur le substrat, ou de sorties (Z') pour extraire les signaux détectés par le dispositif
caractérisé en ce que l'une au moins des deux plages conductrices d'entrée ou de sortie est subdivisée en sous-plages, électriquement séparées, et en ce que les moyens électriques d'entrée comprennent un répartiteur, propre à alimenter séparément les sous-plages d'entrée, tandis que les moyens électriques de sortie comprennent un coupleur propre à combiner les signaux électriques provenant desdites sous-plages de sortie.

2. Transducteur selon revendication 1, caractérisé en ce que les doigts présentent des géométries individuelles qui varient progressivement le long du ruban de substrat pour couvrir une large bande de fréquences.

3. Transducteur selon la revendication 2, caractérisé en ce que la largeur d'un doigt est sensiblement un sous-multiple prédéterminé de la demi-longueur d'onde acoustique instantanée associée, tandis que la distance entre doigts adjacents est sensiblement égale à ce sous-multiple, ou multiple de celui-ci.

4. Transducteur selon l'une des revendications précédentes, caractérisé en ce que le nombre de sous-plages est d'au moins trois, quatre ou cinq.

5. Transducteur selon l'une des revendications précédentes, caractérisé en ce que les doigts ont une longueur variable le long de la rangée, en vue d'obtenir un diagramme de rayonnement acoustique particulier, et en ce que le répartiteur alimente les sous-plages (15M, 15G, 15D) en fonction de la distribution des longueurs variables de doigts.

6. Transducteur selon la revendication 5, caractérisé en ce que la distribution de longueur de doigts est choisie pour obtenir un transducteur pondéré, possédant une zone centrale (15M) non diffractante, encadrée par deux zones latérales (15G, 15D) diffractantes, et en ce que les sous-plages comprennent une sous-plage centrale, et au moins deux sous-plages latérales qui l'encadrent, et sont alimentées sous signal atténué (LL).

7. Transducteur selon la revendication 6, caractérisé en ce que les sous-plages latérales sont alimentées à partir de la sous-plage centrale par un coupleur en éléments répartis réalisé sur le substrat piézo-électrique.

8. Transducteur selon l'une des revendications précédentes, caractérisé en ce que le répartiteur (RD, CP) est implanté sur le substrat.

9. Dispositif à ondes de surface du type comprenant, sur une grande face d'un substrat piézo-électrique plan :
- un transducteur électrique/acoustique d'entrée comprenant :
. deux plages conductrices d'entrée (15, 16), séparées par un ruban (10) de substrat, sur lequel elles étendent des doigts parallèles respectifs (11, 12) qui s'imbriquent selon un motif choisi pour former une rangée de doigts le long de ce ruban,
. la direction générale du ruban (10) étant inclinée sur la direction des doigts,
. des moyens électriques d'entrée (G, Z) pour appliquer des signaux de haute fréquence entre les plages, de façon à former des sources d'ondes acoustiques de surface, et
- un transducteur acoustique/électrique de sortie comprenant :
. deux plages conductrices de sortie (25, 26), séparées par un ruban (20) de substrat, sur lequel elles étendent des doigts parallèles respectifs (21, 22) qui s'imbriquent selon un motif choisi pour former une rangée de doigts le long de ce ruban,
. la direction générale du ruban (20) étant inclinée sur la direction des doigts,
. des moyens électriques de sortie (Z′) pour extraire les signaux détectés par le dispositif.
caractérisé en ce que l'une au moins des deux plages conductrices de chaque transducteur est subdivisée en sous-plages, électriquement séparées, et en ce que les moyens électriques d'entrée comprennent un répartiteur, propre à alimenter séparément les sous-plages associées audit transducteur d'entrée tandis que les moyens électriques de sortie comprennent un coupleur propre à combiner les signaux électriques provenant des sous-plages associées audit transducteur de sortie.

## Patentansprüche

1. Elektroakustischer Eingangswandler oder akustoelektrischer Ausgangswandler, insbesondere für eine Oberflächenwellenvorrichtung, die auf einer großen Seite eines ebenen piezoelektrischen Substrats folgendes aufweist:
- zwei leitende Eingangs- oder Ausgangsbereiche (15, 16 bzw. 25, 26), die durch ein Substratband (10, 20) voneinander getrennt sind, auf dem sich parallele Finger (11, 12, 21, 22) erstrecken, die gemäß einem Muster ineinandergreifen, das so gewählt ist, daß auf diesem längs des Bandes eine Fingerreihe gebildet wird,
- wobei die allgemeine Richtung des Bandes (10, 20) gegenüber der Richtung der Finger geneigt ist,
- eine elektrische Eingangseinrichtung (G, Z) zum Anlegen der Hochfrequenzsignale zwischen diesen Bereichen, so daß auf dem Substrat akustische Oberflächenwellenquellen gebildet werden, oder eine Ausgangseinrichtung (Z') zur Abgabe der von der Vorrichtung erfaßten Signale,
dadurch gekennzeichnet,
daß wenigstens einer der beiden leitenden Eingangs- oder Ausgangsbereiche in elektrisch voneinander getrennte Teilbereiche unterteilt ist
und daß die elektrische Eingangseinrichtung einen Verteiler aufweist, der die Eingangsteilbereiche getrennt versorgen kann, während die elektrische Ausgangseinrichtung einen Koppler aufweist, der die von diesen Ausgangsteilbereichen kommenden elektrischen Signale kombinieren kann.

2. Wandler nach Anspruch 1,
dadurch gekennzeichnet,
daß die Finger individuelle Formen besitzen, die sich allmählich längs des Substratbands ändern, um ein breites Frequenzband abzudecken.

3. Wandler nach Anspruch 2,
dadurch gekennzeichnet,
daß die Breite eines Fingers im wesentlichen ein vorbestimmter Bruchteil der zugeordneten momentanen halben akustischen Wellenlänge ist, während der Abstand zwischen benachbarten Fingern im wesentlichen gleich diesem Bruchteil oder ein Vielfaches von diesem ist.

4. Wandler nach einem der vorhergehenden Ansprüche,
dadurch gekennzeichnet,
daß die Anzahl der Teilbereiche wenigstens drei, vier oder fünf beträgt.

5. Wandler nach einem der vorhergehenden Ansprüche,
dadurch gekennzeichnet,
daß die Finger längs der Reihe eine veränderliche Länge haben, um ein besonderes akustisches Strahlungsdiagramm zu erreichen,
und daß der Verteiler die Teilbereiche (15M, 15G, 15D) in Abhängigkeit von der Verteilung der veränderlichen Fingerlängen versorgt.

6. Wandler nach Anspruch 5,
dadurch gekennzeichnet,
daß die Fingerlängenverteilung so gewählt ist, daß man einen gewichteten Wandler erhält, der eine nicht beugende mittlere Zone (15M) besitzt, die von zwei beugenden Seitenzonen (15G, 15D) umgeben ist,
und daß die Teilbereiche einen mittleren Teilbereich und wenigstens zwei diesen umgebende seitliche Teilbereiche umfassen und mit einem abgeschwächten Signal (LL) versorgt werden.

7. Wandler nach Anspruch 6,
dadurch gekennzeichnet,
daß die seitlichen Teilbereiche vom mittleren Teilbereich aus durch einen auf dem piezoelektrischen Substrat gebildeten Koppler aus verteilten Elementen versorgt werden.

8. Wandler nach einem der vorhergehenden Ansprüche,
dadurch gekennzeichnet,
daß der Verteiler (RD, CP) in dem Substrat implantiert ist.

9. Oberflächenwellenvorrichtung, die auf einer großen Seite eines ebenen piezoelektrischen Substrats folgendes aufweist:
- einen elektroakustischen Eingangswandler:
-- mit zwei leitenden Eingangsbereichen (15, 16), die durch ein Substratband (10) voneinander getrennt sind, auf dem sich parallele Finger (11, 12) ererstrecken, die gemäß einem Muster ineinandergreifen, das so gewählt ist, daß auf diesem längs des Bandes eine Fingerreihe gebildet wird,
-- wobei die allgemeine Richtung des Bandes (10) gegenüber der Richtung der Finger geneigt ist,
-- mit einer elektrischen Eingangseinrichtung (G, Z) zum Anlegen von Hochfrequenzsignalen zwischen diesen Bereichen, so daß akustische Oberflächenwellenquellen gebildet werden, und
- einen akustoelektrischen Ausgangswandler:
-- mit zwei leitenden Ausgangsbereichen (25, 26), die durch ein Substratband (20) getrennt sind, auf dem sich parallele Finger (21, 22) erstrecken, die gemäß einem Muster ineinandergreifen, das so gewählt ist, daß auf diesem längs des Bandes eine Fingerreihe gebildet wird,
-- wobei die allgemeine Richtung des Bandes (20) gegenüber der Richtung der Finger geneigt ist,
-- mit einer elektrischen Ausgangseinrichtung (Z') zur Abgabe der von der Vorrichtung erfaßten Signale,
dadurch gekennzeichnet,
daß wenigstens einer der beiden leitenden Bereiche jedes Wandlers in elektrisch voneinander getrennte Teilbereiche unterteilt ist
und daß die elektrische Eingangseinrichtung einen Verteiler aufweist, der die dem Eingangswandler zugeordneten Teilbereiche getrennt versorgen kann, während die elektrische Ausgangseinrichtung einen Koppler aufweist, der die elektrischen Signale kombinieren kann, die von den diesem Ausgangswandler zugeordneten Teilbereichen kommen.

## Claims

1. Electric/acoustic input transducer or acoustic! electric output transducer, in particular for a surface wave device, of the type comprising over a large area of a plane piezo-electric substrate:
- two input (15, 16) or output (25, 26) conducting areas separated by a strip (10, 20) of substrate, over which the areas extend respective parallel fingers (11, 12, 21, 22) which interlock in a chosen pattern to form a row of fingers along said strip,
- the general direction of the strip (10, 20) being inclined in the direction of the fingers,
- electrical input means (G, Z) for applying high-frequency signals between the areas, so as to form surface acoustic wave sources on the substrate, or electric output means (Z') for extracting the signals detected by the device,
characterised in that at least one of the two inlet or outlet conducting areas is subdivided into electrically separated sub-areas, and in that the electrical input means comprise a splitter for supplying the input sub-areas separately, whereas the electrical output means comprise a coupler for combining the electrical signals from said output sub-areas.

2. Transducer according to claim 1, characterised in that the fingers each have their own geometry which varies progressively along the strip of substrate so as to cover a wide band of frequencies.

3. Transducer according to claim 2, characterised in that the width of a finger is substantially a predetermined sub-multiple of the half-length of the associated instantaneous acoustic wave, whereas the distance between adjacent fingers is substantially equal to this sub-multiple or a multiple thereof.

4. Transducer according to one of the preceding claims, characterised in that the number of sub-areas is at least three, four or five.

5. Transducer according to one of the preceding claims, characterised in that the fingers have a variable length along the row in order to give a particular graph of acoustic radiation, and in that the splitter supplies the sub-areas (15M, 15G, 15D) in accordance with the distribution of the variable lengths of the fingers.

6. Transducer according to claim 5, characterised in that the distribution of finger lengths is selected to give a weighted transducer having a non-diffracting central zone (15M), bordered by two lateral diffracting zones (15G, 15D), and in that the sub-areas comprise a central sub-area and at least two lateral sub-areas bordering same, and are supplied under an attenuated signal (LL).

7. Transducer according to claim 6, characterised in that the lateral sub-areas are supplied from the central sub-area by a coupler of distributed elements which is formed on the piezo-electric substrate.

8. Transducer according to one of the preceding claims, characterised in that the splitter (RD, CP) is implanted in the substrate.

9. Surface wave device of the type comprising over a large area of a plane piezoelectric substrate:
- an electric/ acoustic input transducer comprising:
. two input (15, 16) conducting areas separated by a strip (10) of substrate, over which the areas extend respective parallel fingers (11, 12) which interlock in a chosen pattern to form a row of fingers along said strip,
. the general direction of the strip (10) being inclined in the direction of the fingers, electrical input means (G, Z) for applying high-frequency signals between the areas, so as to form surface acoustic wave sources, and
- an acoustic/ electric output transducer comprising:
. two (25, 26) conducting areas separated by a strip (20) of substrate, over which the areas extend respective parallel fingers (21, 22) which interlock in a chosen pattern to form a row of fingers along said strip,
. the general direction of the strip (20) being inclined in the direction of the fingers,
. electrical output means (Z') for extracting the signals detected by the device,
characterised in that at least one of the two conducting areas of each transducer is subdivided into electrically separate sub-areas, and in that the electrical input means comprise a splitter for supplying separately the input sub-areas associated with said input transducer, whereas the electrical output means comprise a coupler for combining the electrical signals from the sub-areas associated with said output transducer.
